(19) **Europäisches Patentamt**

**European Patent Office**

**Office européen des brevets**

(11) **EP 1 212 691 B1**

(12) **EUROPÄISCHE PATENTSCHRIFT**

(45) Veröffentlichungstag und Bekanntmachung des Hinweises auf die Patenterteilung:
**06.08.2003 Patentblatt 2003/32**

(21) Anmeldenummer: **00943652.8**

(22) Anmeldetag: **30.05.2000**

(51) Int Cl.⁷: **G06F 17/50**

(86) Internationale Anmeldenummer:
**PCT/DE00/01754**

(87) Internationale Veröffentlichungsnummer:
**WO 00/077658 (21.12.2000 Gazette 2000/51)**

(54) **RECHNERGESTÜTZTES VERFAHREN ZUR PARALLELEN BERECHNUNG DES ARBEITSPUNKTES ELEKTRISCHER SCHALTUNGEN**

COMPUTER-ASSISTED METHOD FOR THE PARALLEL CALCULATION OF THE OPERATING POINT OF ELECTRIC CIRCUITS

PROCEDE ASSISTE PAR ORDINATEUR POUR LE CALCUL PARALLELE DU POINT DE FONCTIONNEMENT DE CIRCUITS ELECTRIQUES

(84) Benannte Vertragsstaaten:
**DE FR GB**

(30) Priorität: **15.06.1999 DE 19927301**

(43) Veröffentlichungstag der Anmeldung:
**12.06.2002 Patentblatt 2002/24**

(73) Patentinhaber: **Infineon Technologies AG 81669 München (DE)**

(72) Erfinder: **DENK, Georg D-83026 Rosenheim (DE)**

(74) Vertreter: **Barth, Stephan Manuel, Dr. Reinhard-Skuhra-Weise & Partner Gbr, Patentanwälte Friedrichstrasse 31 80801 München (DE)**

(56) Entgegenhaltungen:
**US-A- 5 181 179**

• **YILMAZ E ET AL: "Applying globally convergent techniques to conventional DC operating point analyses" PROCEEDINGS 32ND ANNUAL SIMULATION SYMPOSIUM, PROCEEDINGS 32ND ANNUAL SIMULATION SYMPOSIUM, SAN DIEGO, CA, USA, 11-15 APRIL 1999, Seiten 153-158, XP002173258 1999, Los Alamitos, CA, USA, IEEE Comput. Soc, USA ISBN: 0-7695-0128-1**

**Beschreibung**

Die vorliegende Erfindung betrifft ein rechnergestütztes, paralleles und partitionierendes Verfahren zur Arbeitspunkt-Berechnung von Schaltungen gemäß dem Oberbegriff des Anspruchs 1.

Ein derartiges Verfahren ist bekannt aus N. Fröhlich, B. Riess, U. Wever, Q. Zheng: "A new approach for parallel simulation of VLSI circuits on a transistor level" (IEEE Transaction on Circuits and Systems - I: Fundamental Theory and Applications, Vol. 45, No. 6, June 1998, Seiten 601 bis 613).

In H. Spiro "Simulation integrierter Schaltungen" (2. Auflage, R. Oldenbourg Verlag, München, Wien 1990) ist ein Aufladeverfahren bekannt, das im nicht-parallelen Fall die in einer elektrischen Schaltung vorhandenen dynamischen Elemente, wie Kapazitäten und/oder Induktivitäten, dazu verwendet, um über eine Pseudo-Transientenanalyse den Arbeitspunkt zu berechnen. Die dynamischen Elemente werden dabei schrittweise, von einem Wert Null ausgehend, auf einen im Prinzip beliebig hohen Wert, insbesondere auf den Wert "1" hochgefahren.

Die rechnergestützte Simulation elektrischer Schaltungen hat bei der Entwicklung sehr großer Schaltungen, also Schaltungen mit einer sehr großen Anzahl von Elementen, eine immer größere Bedeutung erlangt. Insbesondere bei der Entwicklung von Computerchips mit einer Vielzahl, beispielsweise mehrere hunderttausend Transistoren, erweist sich eine serielle Bearbeitung für die Ermittlung der Schaltungsgrößen durch einen Rechner wegen des zu großen Zeitaufwands als unbrauchbar.

In der WO 98/24039 wird deshalb vorgeschlagen, eine große Schaltung zu partitionieren und die Partitionen jeweils von verschiedenen Rechnern bearbeiten zu lassen.

Üblicherweise werden bei der Berechnung zuerst der Arbeitspunkt, das heißt die Potenziale aller Knoten als Grundlage für weitere Analysen, wie beispielsweise Transienten- oder Wechselstromanalysen, ermittelt.

Zur parallelen Berechnung wird in U. Wever, Q. Zheng et al.: "Domain Decomposition Methods for Circuit Simulation" (Proceedings of the 8th Workshop on Parallel and Distributed Simulation, PADS '94 Edinburgh, Scotland, UK, S. 183-186, Juli 1994) und in U. Wever, Q. Zheng: "Parallel Transient Analysis for Circuit Simulation" (Procceedings of the 29th Annual Hawaii International Conference on System Sciences, S. 442-447, 1996) eine Implementierung des Newton-Verfahrens vorgeschlagen. Nachteiligerweise kann hier, aufgrund schlechter Konvergenzeigenschaften, nur bei Vorliegen hinreichend guter Schätzungen des Arbeitspunktes Konvergenz erzielt werden. Derartige gute Schätzungen sind in der Regel jedoch bei großen Schaltungen schwer oder nicht zu bewerkstelligen.

Der vorliegenden Erfindung liegt deshalb die Aufgabe zugrunde, ein rechnergestütztes Verfahren zur parallelen Berechnung des Arbeitspunktes elektrischer Schaltungen zu schaffen, das eine einfache, sichere und schnelle Berechnung des Arbeitspunktes der Schaltung gewährleistet.

Diese Aufgabe wird erfindungsgemäß durch das Verfahren gemäß Patentanspruch 1 gelöst.

Bei dem Verfahren wird zur parallelen Berechnung des Arbeitspunktes das Aufladeverfahren verwendet, welches sehr gute Konvergenzeigenschaften aufweist.

In einer Ausführungsform nach der Erfindung können zusätzlich an geeigneten Stellen, beispielsweise an oder zwischen mehreren Knoten dynamische Elemente, wie beispielsweise Kapazitäten oder Induktivitäten, mit vorbestimmten bekannten Werten zusätzlich eingebaut werden. Hierdurch können Schwierigkeiten bei der Berechnung aufgrund einer zu geringen Anzahl von dynamischen Elementen vermieden werden.

Hierzu können die zusätzlich in die Schaltung eingebrachten dynamischen Elemente von einem Anfangswert, beispielsweise gegen Unendlich, für den die Arbeitspunktberechnung trivial ist, schrittweise auf Null verringert werden, so dass wiederum die ursprüngliche Schaltung simuliert wird.

In einer bevorzugten Ausführungsform der Erfindung wird wenigstens ein Knotenpunkt, also ein Verbindungspunkt von wenigstens zwei Strompfaden, der Schaltung mittels einer Kapazität mit einem vorbestimmten Wert mit einem vorbestimmten Potenzial verbunden.

In weiterer Ausgestaltung der Erfindung kann aber auch an jeden Knoten über alle Partitionen eine Kapazität angeschlossen werden, deren zweiter Anschluss jeweils an einem vorbestimmten Potenzial, beispielsweise an Masse liegt. Diese Vorgehensweise hat den Vorteil, dass der Arbeitspunkt, also die jeweiligen Potenziale der einzelnen Knotenpunkte, für einen gegen Unendlich gehenden Anfangswert für die Kapazitäten, aufgrund einer Lösung der dann expliziten Gleichung, für die Schaltung trivial zu berechnen ist. Über eine schrittweise Veränderung des Wertes für die Kapazitäten kann dann durch geeignete Neuwahl des Wertes für die Kapazitäten die Schaltungssimulation verändert werden, bis sich eine Berechnung des Arbeitspunktes der Schaltung für einen Wert der Kapazitäten gegen Null oder nahezu gegen Null ergibt.

Durch diese Implementierung des Aufladeverfahrens auch für parallele Berechnung einer elektrischen Schaltung kann vorteilhafterweise eine sehr große Schaltung mit einer Vielzahl von Transistoren selbst bei einer geringeren Zahl von dynamischen Elementen auf schnelle und einfache Weise berechnet werden. Für die jeweilige Neufestlegung des Wertes für die Kapazität mit dem Ziel, diesen gegen Null gehen zu lassen, sind verschiedene Vorgehensweisen denkbar, wobei als Entscheidungskriterium der Schwierigkeitsgrad der Berechnung des Arbeitspunktes des jeweiligen vorhergehenden Schrittes in Frage kommt.

Der Arbeitspunkt, der sich durch Lösung einer nicht-linearen Gleichung für jeweils einen bestimmten Wert der Kapazitäten ergibt, kann beispielsweise iterativ mit dem Newton-Verfahren gelöst werden. Für die Wahl des nächsten Wertes für "C" können dann die Anzahl der zur Lösung notwendigen Iterationsschritte verwendet werden, bis ein vorbestimmter Wert für "C" unterschritten wird.

Weitere vorteilhafte Ausgestaltungen der Erfindung ergeben sich aus den Unteransprüchen.

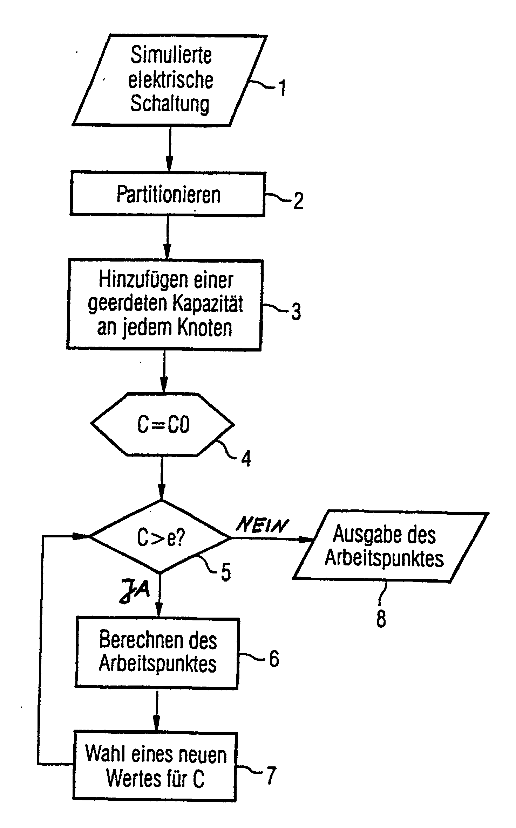

Die Erfindung wird nachfolgend anhand eines in der Zeichnung dargestellten Ausführungsbeispiels erläuter. In der Zeichnung zeigt die einzige Figur ein Ablaufdiagramm, in dem die einzelnen Verfahrensschritte des Verfahrens dargestellt sind.

Nach der Zeichnung liegt als Ausgangspunkt 1 eine Simulation einer elektrischen Schaltung, beispielsweise in der Schaltungsbeschreibungssprache SPICE vor. Diese wird in einem ersten Verarbeitungsprozess 2, wie beispielsweise in WO 98/24039 als "Clustering-Verfahren" beschrieben, partitioniert, so dass sich einzelne Partitionen beziehungsweise Teile der Schaltungen, die möglichst mit gleichem Schwierigkeitsgrad berechenbar sind, ergeben.

In einem weiteren Arbeitsschritt 3 wird nun jedem Knotenpunkt der Schaltung, also einem Verbindungspunkt von wenigstens zwei Leitern beziehungsweise Strompfaden eine geerdete Kapazität hinzugefügt. Selbstverständlich ist es auch denkbar, eine Kapazität, deren zweiter Anschluss an einem vorbestimmten Potenzial liegt, hinzuzufügen, wobei sich sowohl Potenziale als auch die Werte für die Kapazitäten jedes Knoten unterscheiden können. Aus Effizienz-, Stabilitäts- und berechnungsökonomischen Gründen liegt jede Kapazität mit ihrem zweiten Anschluss an dem gleichen Potenzial, beispielsweise Masse, wobei zudem aus denselben Gründen für alle Kapazitäten in Schritt 4 ein identischer hoher Wert C0 gewählt wird.

Für diesen Wert C0 wird nun in einem weiteren Schritt 6 für jede Partition beziehungsweise Teilschaltung der Arbeitspunkt berechnet, wobei die erforderlichen Kopplungswerte, also die Werte für die Kopplungspunkte beziehungsweise Schnittstellen benachbarter Partitionen, für die Berechnung der Arbeitspunkte benachbarter Partitionen ausgetauscht und einberechnet werden.

Hierbei kann aus Effizienzgründen vorteilhafterweise eine Partition, welche im Folgenden als "Master" bezeichnet wird, die Steuerung des Aufladeverfahrens übernehmen. Der Master bestimmt dann den Anfangswert C0 für die Kapazitäten, wobei es auch denkbar ist, den Anfangswert extern, beispielsweise vom Benutzer, vorzugeben. Dieser Wert C0 wird dann an alle übrigen Partitionen, im Folgenden als Slaves bezeichnet, übergeben. Nachfolgend wird sowohl in der Master-Partition als auch in allen Slave-Partitionen der Arbeitspunkt berechnet, wobei selbstverständlich der volle Quellenvektor, der die in der Schaltung vorhandenen Energiequellen darstellt, an der Schaltung anliegt.

Ausgehend von einem zu lösenden Gesamtproblem

$$x=(m, s_i, ..., s_p)$$

wobei

m     die Unbekannten des Masters,
p     die Anzahl der Partitionen,
$S_i$     die Unbekannten der Partition i

bezeichnet, führt das Aufladeverfahren hierbei auf das Differentialgleichungssystem,

$$f(x,t)+D\frac{dx}{dt} = 0$$

wobei
$D=diag(C,...C,0,...,0)$ und
t die Zeit bezeichnet.

Dieses Differenzialgleichungssystem kann beispielsweise mit dem impliziten Euler-Verfahren gelöst werden, was auf die nicht-lineare Gleichung

$$f(x^{k+1}, t^{k+1})+\frac{1}{h}D(x^{k+1} - x^k) = 0$$

führt. Dabei ist $x^k$ die Lösung zum Zeitpunkt $t^k$ für k = 0, 1, usw. und h die Schrittweite $t^{k+1} - t^k$. Diese nicht-lineare Gleichung kann beispielsweise iterativ mit dem Newton-Verfahren

$$x_{n+1}^{k+1} = x_n^{k+1} - \left( f_x(x_n^{k+1}, t^{k+1}) + \frac{1}{h}D \right)^{-1} \cdot \left( f(x_n^{k+1}, t^{k+1}) + \frac{1}{h}D(x_n^{k+1} - x^k) \right)$$

für n = 0, 1, usw. gelöst werden.

Bei der parallelen Berechnung werden dann vom Master nur die Unbekannten "m" berechnet, wobei die Unbekannten "$s_i$" für den Master Festwerte darstellen. Damit eine Lösung dieses berechnet werden kann, werden von den Slaves bzw. Slave-Partitionen in jedem Iterationsschritt des Masters die korrigierten Werte $s_i^{k+1}$ berechnet und dem Master mitgeteilt. Hierzu muss von den Slaves das nicht-lineare Gleichungssystem

$$f_i(s_i^{k+1}, m_n^{k+1}, t^{k+1}) + \frac{1}{h}D_i((s_i^{k+1}, m_n^{k+1}) - (s_i^k, m^k)) = 0$$

gelöst werden, wobei $f_i$ und $D_i$ die entsprechenden Gleichungen und Matrizen für den Slave "i" bezeichnen. Diese nicht-lineare Gleichung kann ebenfalls mit dem Newton-Verfahren berechnet werden, wobei nicht notwendigerweise alle Iterationsschritte bis zur Konvergenz durchgeführt werden müssen.

Die Ergebnisse der Slaves werden daraufhin in das Gleichungssystem des Masters eingesetzt, woraufhin der Master den Ausdruck $m^{k+1}$ berechnen kann.

In einem nächsten Schritt 7 wird ein neuer Wert "$C_{neu}$" für "C" vom Master bestimmt, wobei auch die Slaves Vorschläge machen können. Um das Ziel, nämlich einen Wert für "C" gegen Null beziehungsweise kleiner als einen vorbestimmten Wert e und damit eine Berechnung der ursprünglichen Schaltung zu erreichen, wird die Wahl des neuen Wertes "$C_{neu}$" für "C" in Abhängigkeit von der Schwierigkeit der Berechnung des vorhergehenden Schrittes mit dem Wert "$C_{alt}$" für "C" getroffen.

Hierbei sind verschiedene Vorgehensweisen denkbar, beispielsweise die Wahl von "$C_{neu}$" in Abhängigkeit einer Analyse der Anzahl der Iterationsschritte, die der Master zur Berechnung des nicht-linearen Gleichungssystems für den vorhergehenden Wert "$C_{alt}$" für "C" benötigt hat:

$$C_{neu} = \begin{cases} C_{alt}/2 & \text{für } n < n_1 \\ C_{alt} & \text{für } n_1 \leq n \leq n_2 \\ C_{alt} \cdot 2 & \text{für } n_2 > n \end{cases}$$

Wobei "n" die Anzahl der Iterationen des Masters und "$n_1$", "$n_2$" vom Benutzer vorgegebene Parameter sind. Anstelle der Halbierung beziehungsweise Verdopplung von "$C_{alt}$" sind selbstverständlich auch andere Strategien zur Verkleinerung beziehungsweise Vergrößerung von "$C_{alt}$" möglich. Zusätzlich kann auch die Anzahl der Iterationsschritte, die die Slaves bzw. Slave-Partitionen zur Lösung ihres nicht linearen Gleichungssystems benötigt haben, berücksichtigt werden, beispielsweise durch die Wahl von

$$n = \max\left( n, \sum_{i=1}^{n} n_i, slave1, ...., \sum_{i=1}^{n} n_i, slavep \right)$$

wobei $n_{i, Slavej}$ die Anzahl der Iterationsschritte des Slaves j, während der i-ten Iteration des Masters bezeichnet. Hierbei ist anzumerken, dass die Wahl eines Wertes für "C" nur einen Einfluss auf die Effizienz des Verfahrens, nicht jedoch auf den Arbeitspunkt selbst hat.

Nach Erreichen eines Wertes von für "C" kleiner oder gleich einem vorgegebenen Wert e wird die Berechnung an der Verzweigung 5 abgebrochen, wobei in einem letzten Schritt der Wert für C auf "0" gesetzt werden kann. Hierdurch steht als Ergebnis 8 der Arbeitspunkt der ursprünglichen Schaltung fest und kann über Ausgabeeinheiten, wie beispielsweise Bildschirm, Drucker oder ähnlichem, ausgegeben und/oder in einem Speicher als Grundlage für weitere Analysen der Schaltung zwischengespeichert werden.

Durch das erfindungsgemäße Verfahren kann ein Arbeitspunkt einer sehr große elektrische Schaltung vorteilhafterweise von einer Vielzahl von Rechnern oder Prozessoren parallel berechnet werden, wobei der Nachteil bekannter paralleler Berechnungsarten, nämlich fehlende Konvergenz bei ungünstigen Anfangswerten, vermieden werden kann. Der Aufwand für die Berechnung hinsichtlich Iterationsschritten und schrittweisem Setzen eines Wertes für "C" wird durch die parallele Berechnung aufgrund der Verteilung auf mehrere Prozessoren in einem vertretbaren Rahmen gehalten.

Der so berechnete Arbeitspunkt dient dann als Grundlage für weitere Analysen, beispielseise der Wechselstromanalyse einer Schaltung.

**Patentansprüche**

1. Rechnergestütztes Verfahren zur parallelen Berechnung des Arbeitspunktes elektrischer Schaltungen,

   - bei dem die Schaltung in einem ersten Schritt in mehrere Partitionen partitioniert (2) wird,

     **dadurch gekennzeichnet, dass**

   - zur parallelen Berechnung (6) der einzelnen Partitionen das Aufladeverfahren angewendet wird, wobei an jedem Knotenpunkt der Schaltung ein dynamisches Element (C, L) vorgesehen (3) wird.

2. Rechnergestütztes Verfahren nach Anspruch 1,
   **dadurch gekennzeichnet, dass**
   jeder Knotenpunkt der Schaltung mittels jeweils einer Kapazität (C) mit jeweils einem vorbestimmten Wert mit jeweils einem Potenzial verbunden wird, so dass ein Arbeitspunkt der modifizierten Schaltung berechnet (6) werden kann.

3. Rechnergestütztes Verfahren nach Anspruch 2,
   **dadurch gekennzeichnet, dass**
   an jedem Knoten einer Partition eine Kapazität mit demselben Wert (C0) vorgesehen (4) wird.

4. Rechnergestütztes Verfahren nach Anspruch 2 oder 3,
   **dadurch gekennzeichnet, dass**
   jeder Knoten einer Partition mittels einer Kapazität mit demselben Potenzial verbunden wird.

5. Rechnergestütztes Verfahren nach Anspruch 2,
   **dadurch gekennzeichnet, dass**
   an jedem Knoten aller Partitionen eine Kapazität mit demselben Wert (C0) vorgesehen (4) wird.

6. Rechnergestütztes Verfahren nach Anspruch 2 oder 5,
   **dadurch gekennzeichnet, dass**
   jeder Knoten aller Partitionen mittels einer Kapazität mit demselben Potenzial verbunden wird.

7. Rechnergestütztes Verfahren nach einem der Ansprüche 2 bis 5,
   **dadurch gekennzeichnet, dass**
   das Potenzial auf Masse liegt.

8. Rechnergestütztes Verfahren nach einem der Ansprüche 2 bis 6,
   **dadurch gekennzeichnet, dass**

   - bei geeigneter schrittweiser Veränderung (7) des Wertes (C) der Kapazität jeweils der Arbeitspunkt der Schaltung berechnet (6) wird und
   - dieser Schritt solange wiederholt wird, bis die Werte der Kapazitäten nahezu Null sind.

9. Computerprogrammprodukt, welches in einen Arbeitsspeicher einer Rechenanlage geladen werden kann, mit einem Softwarecode für das Durchführen des Verfahrens nach einem der vorhergehenden Ansprüche, wenn das Computerprogrammprodukt auf einer Rechenanlage läuft.

**10.** Datenträger mit einem Computerprogrammprodukt nach Anspruch 9.

**Claims**

**1.** Computer-aided method for parallel calculation of the operating point of electrical circuits,

- in which the circuit is partitioned (2) into a number of partitions in a first step,

**characterized in that**

- the charging method is used for the parallel calculation (6) of the individual partitions, a dynamic element (C, L) being provided (3) at each node of the circuit.

**2.** Computer-aided method according to Claim 1, **characterized in that** each node of the circuit is connected to in each case a predetermined value having in each case a potential by means of in each case one capacitance so that an operating point of the modified circuit can be calculated (6).

**3.** Computer-aided method according to Claim 2, **characterized in that** a capacitance having the same value (C0) is provided (4) at each node of a partition.

**4.** Computer-aided method according to Claim 2 or 3, **characterized in that** each node of a partition is connected to the same potential by means of a capacitance.

**5.** Computer-aided method according to Claim 2, **characterized in that** a capacitance having the same value (C0) is provided (4) at each node of all partitions.

**6.** Computer-aided method according to Claim 2 or 5, **characterized in that**
each node of all partitions is connected to the same potential by means of a capacitance.

**7.** Computer-aided method according to one of Claims 2 to 5, **characterized in that** the potential is connected to earth.

**8.** Computer-aided method according to one of Claims 2 to 6, **characterized in that**

- the operating point of the circuit is calculated (6) in each case with a suitable step-by-step change (7) in the value of (C) of the capacitance, and
- this step is repeated until the values of the capacitances are almost zero.

**9.** Computer program product which can be loaded into a main memory of a computer system, with a software code for carrying out the method according to one of the preceding claims when the computer program product is running on a computer system.

**10.** Data carrier with a computer program product according to Claim 9.

**Revendications**

**1.** Procédé assisté par ordinateur pour le calcul parallèle du point de fonctionnement de circuits électriques,

- avec lequel le circuit est dans une première étape partitionné en plusieurs partitions (2),

**caractérisé en ce que**

- le procédé de charge est utilisé pour le calcul parallèle (6) de chacune des partitions, un élément dynamique (C, L) étant prévu (3) à chaque point nodal du circuit.

**2.** Procédé assisté par ordinateur selon la revendication 1,
**caractérisé en ce que** chaque point nodal du circuit est connecté chaque fois à un potentiel au moyen chaque fois d'une capacitance (C) présentant chaque fois une valeur prédéterminée, de sorte qu'un point de fonctionnement du circuit modifié peut être calculé (6).

3. Procédé assisté par ordinateur selon la revendication 2,
   **caractérisé en ce qu'**une capacitance de même valeur (C0) est prévue (4) à chaque noeud d'une partition.

4. Procédé assisté par ordinateur selon une des revendications 2 ou 3,
   **caractérisé en ce que** chaque noeud d'une partition est connecté au même potentiel au moyen d'une capacitance.

5. Procédé assisté par ordinateur selon la revendication 2,
   **caractérisé en ce qu'**une capacitance présentant la même valeur (C0) est prévue (4) à chaque noeud de toutes les partitions.

6. Procédé assisté par ordinateur selon une des revendications 2 ou 5,
   **caractérisé en ce que** chaque noeud de toutes les partitions est connecté au même potentiel au moyen d'une capacitance.

7. Procédé assisté par ordinateur selon les revendications 2 à 5,
   **caractérisé en ce que** le potentiel se trouve à la masse.

8. Procédé assisté par ordinateur selon une des revendications 2 à 6,
   **caractérisé en ce que**

   - le point de fonctionnement du circuit est calculé (6) pour chaque modification graduelle adéquate (7) de la valeur (C) de la capacitance et
   - cette étape est répétée jusqu'à ce que la valeur des capacitances soit de proche de zéro.

9. Programme informatique, qui peut être chargé dans une mémoire de travail d'un ordinateur, avec un code logiciel pour réaliser le procédé selon une des revendications précédentes lorsque le programme informatique est exécuté dans un ordinateur.

10. Support de données contenant un programme informatique selon la revendication 9.

```
┌─────────────────┐
│   Simulierte    │
│   elektrische   ╲──── 1
│   Schaltung     │
└─────────────────┘
         │
         ▼
┌─────────────────┐
│  Partitionieren │──── 2
└─────────────────┘
         │
         ▼
┌─────────────────┐
│ Hinzufügen einer│
│geerdeten Kapazität│──── 3
│  an jedem Knoten │
└─────────────────┘
         │
         ▼
     ⬡ C = C0 ⬡ ──── 4
         │
         ▼
      ◇ C > e? ◇ ───── NEIN ───►  ┌─────────────────┐
         │         └── 5          │  Ausgabe des    ╲
        JA                        │  Arbeitspunktes  │
         │                        └─────────────────┘
         ▼                                  └── 8
┌─────────────────┐
│  Berechnen des  │──── 6
│  Arbeitspunktes │
└─────────────────┘
         │
         ▼
┌─────────────────┐
│ Wahl eines neuen│──── 7
│   Wertes für C  │
└─────────────────┘
```